Europäisches Patentamt

European Patent Office

Office européen des brevets

(19)

(11) Veröffentlichungsnummer: **0 070 351 B1**

(12) # EUROPÄISCHE PATENTSCHRIFT

(45) Veröffentlichungstag der Patentschrift:
22.05.85

(51) Int. Cl.⁴: **H 01 J 49/04**

(21) Anmeldenummer: **82100811.7**

(22) Anmeldetag: **04.02.82**

(54) Elektrisch leitende Probenhalterung für die Analysentechnik der Sekundärionen-Massenspektrometrie.

(30) Priorität: **21.07.81 DE 3128814**

(43) Veröffentlichungstag der Anmeldung:
**26.01.83 Patentblatt 83/4**

(45) Bekanntmachung des Hinweises auf die Patenterteilung:
**22.05.85 Patentblatt 85/21**

(84) Benannte Vertragsstaaten:
**CH DE FR GB LI NL**

(56) Entgegenhaltungen:
**US - A - 3 909 611**

**APPLIED PHYSICS, Vol. 12, No. 2, Feb. 1977, New York
K. WITTMAACK "Raster Scanning Depth Profiling of
Layer Structures" Seiten 149-156
APPLIED PHYSICS LETTERS, Vol. 37, No. 3, 1. August
1980, New York K. WITTMAACK "Dynamic range of 106
in depth profiling using secondary-ion mass
spectrometry" Seiten 285-287**

(73) Patentinhaber: **Siemens Aktiengesellschaft, Berlin und
München Wittelsbacherplatz 2, D-8000 München 2 (DE)**

(72) Erfinder: **Von Criegern, Rolf, Dipl.-Phys.,
Lilienstrasse 27, D-8192 Geretsried (DE)**
Erfinder: **Weitzel, Ingo, Dipl.-Phys., Ahornring 3,
D-8028 Taufkirchen (DE)**

ACTORUM AG

## Beschreibung

Die vorliegende Patentanmeldung betrifft eine elektrisch leitende Probenhalterung für die Analysentechnik der Sekundärionen-Massenspektrometrie, bei der die zu analysierende Probe im Vakuum mit einem Ionen- oder Neutralteilchenstrahl beschossen wird, hierdurch an der getroffenen Stelle abgetragen wird und die bei der Abtragung entstehenden Sekundärionen in einem Massenspektrometer analysiert werden, sowie ein Verfahren zum Betrieb dieser Probenhalterung. Unter einem Neutralteilchenstrahl ist vorzugsweise ein Atom- oder Molekülstrahl zu verstehen.

Die Analysenmethode der Sekundärionen-Massenspektrometrie (SIMS) ist sehr empfindlich. Sie kann Spuren von Verunreinigungen in einem Material bis in den ppm-Bereich, in manchen Fällen bis in den ppb-Bereich, analysieren. Aus diesem Grunde besitzt die SIMS grosse Bedeutung für die Untersuchung von Halbleiterkristallen, z.B. für die Messung der Konzentration eines ionenimplantierten Dotierstoffes in Abhängigkeit von der Probentiefe. Des weiteren ist diese Technik auch für die allgemeine Spurenanalyse anwendbar.

Für die Erreichung höchster Nachweisempfindlichkeiten ist es erforderlich, Beiträge zum Messsignal ausschliesslich aus dem Mittelbereich der abgetragenen Schicht, dem sogenannten Sputterkrater, zu erfassen und alle Sekundärionen vom Rand des Kratzers oder seiner Umgebung von der Messung fernzuhalten.

Es ist bekannt [siehe Aufsatz von K. Wittmaack in Appl. Phys. 12, S. 149-156 (1977)], den Ionenstrahl über eine quadratische Fläche von z.B. 1 mm$^2$ zu rastern und dadurch einen Abtragungskrater mit flachem Boden zu erzeugen. Um Signalbeiträge aus dem Rand des Kraters nicht mitzumessen, wird die Messerfassung (Impulszählung) elektronisch unterbrochen, sobald der Ionenstrahl einen mittleren Bereich des Kraters («elektronisches Gate») verlässt. Schnelle Neutralteilchen, die im Ionenstrahl entstehen und die Strahlrasterung nicht mitmachen (weil sie nicht ablenkbar sind), können vom «elektronischen Gate» nicht daran gehindert werden, Signalbeiträge aus dem Kraterrand oder aus der Umgebung des Kraters auszulösen.

Wie aus einem Aufsatz von K. Wittmaack und J. B. Clegg aus Appl. Phys. Lett. 37 (3) S. 285-287 (1.8. 1980) zu entnehmen ist, können derartige Neutralteilchen durch Abknicken des Ionenstrahls zu einem wesentlichen Anteil am Auftreffen auf der Probe gehindert werden.

Folgende Störkomponente können jedoch weder durch die elektronische Randausblendung («Gate») noch durch einen Ionenstrahlknick eliminiert werden:

1. Schnelle Neutralteilchen, die erst nach dem Ionenstrahlknick entstehen,

2. Ionen aus weitreichenden Ausläufern des Ionenstrahls (abhängig von den Fokussierungsbedingungen) und

3. Elektronen aus einem simultan auf die Probe gerichteten Elektronenstrahl, mit dem Aufladungen der Probe durch den Ionenstrahl vermieden werden sollen («Kompensation» von Aufladungen bei Isolatoren und Halbleitern).

Die hier genannten Teilchenarten werden dadurch zu störenden, die Nachweisempfindlichkeit von Verunreinigungen (Dotierstoffatomen u. a.) beeinträchtigenden Komponenten, dass sie unerwünschte Signalanteile aus dem Bereich des Kraterrandes oder der Umgebung des Kraters auslösen. Ähnliche Störeffekte treten auch bei Anwendung eines Neutralteilchenstrahls auf.

Die Aufgabe, die der Erfindung zugrunde liegt, besteht in der Vermeidung unerwünschter Messsignale und damit in der Eliminierung des Kraterrandes und seiner Umgebung.

Diese Aufgabe wird bei einer eingangs genannten, elektrisch leitenden Probenhalterung gelöst, die erfindungsgemäss gekennzeichnet ist durch einen, die Probe aufnehmenden Probenteller, der bezüglich seiner, dem Ionen oder Neutralteilchenstrahl zugewandten Oberfläche so beschaffen ist, dass die Probe umgebungsfrei voll im Inneren des vom Ionen- oder Neutralteilchenstrahl getroffenen oder überstrichenen Bereiches angeordnet ist. Auf diese Weise kommen bei Anwendung eines Ionenstrahles die Umkehrpunkte der Ionenstrahlbewegung beim Rastern und damit der «Kraterrand» ausserhalb der Grenzen der Probe zu liegen. Bei Anwendung eines Neutralteilchenstrahls kann in analoger Weise erreicht werden, dass der Rand des von ihm getroffenen Bereichs ausserhalb der Grenzen der Probe liegt. Signalbeiträge aus der Umgebung der Probe, also auch des Kraterrandes werden dadurch eliminiert, dass die Probe im Prinzip trägerfrei vor einem Loch im Probenteller montiert wird. Dadurch können keinerlei Primärteilchen mehr in der Umgebung des analysierten Kraters der Probe auftreffen, sondern sie gelangen nach Durchtritt durch das Loch in ausreichender Entfernung auf eine Fläche, von der das Massenspektrometer keine Messsignale mehr akzeptiert.

Weitere Ausgestaltungen der Erfindung sind aus den Unteransprüchen zu entnehmen.

Im folgenden wird auf die in der Zeichnung befindlichen Figuren 1 bis 4 Bezug genommen, aus denen weitere Vorteile der Erfindung zu entnehmen sind. Dabei zeigen

die Figuren 1 und 2 schematisch im Schnittbild zwei verschiedene Ausführungsformen von Probenhalterungen, die für einen Beschuss mit Ionenstrahlen geeignet sind,

die Figur 3 eine Draufsicht auf die Probenhalterung gemäss Figur 2 und

die Figur 4 ein mit einer erfindungsgemässen Probenhalterung aufgenommenes Tiefenprofil von ionenimplantiertem Bor in Silizium, wobei die Messung unter Verwendung eines $O_2{}^+$-Ionenstrahls erfolgte.

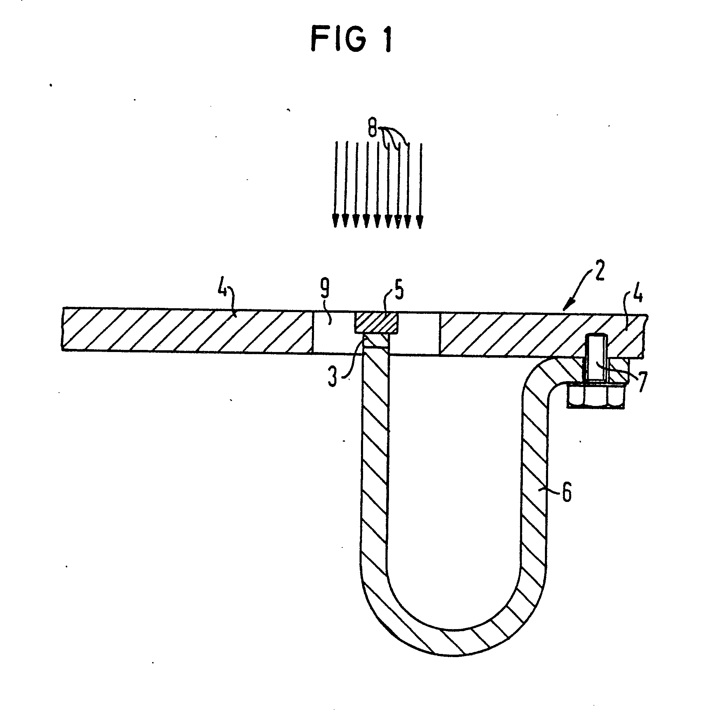

In der Figur 1 ist eine Probenhalterung dargestellt, bei der Probenteller 2 aus zwei Teilen 3 und 4 z. B. aus Aluminium besteht. Diese Teile 3 und 4 sind konzentrisch zueinander angeordnet. Das innere Teil 3, welches die zu analysierende Probe 5 trägt, besteht aus einem Podest, welches sich in einem U-förmig gebogenen Haltearm 6 fortsetzt, wobei der Haltearm 6 an seinem, der Probenauflagefläche 3 entgegengesetzten Ende durch eine Schraube 7 mit dem äusseren Teil 4 des Probentellers 2 elektrisch und mechanisch fest verbunden ist. Die Probenauflagefläche 3 ist bezüglich ihrer räumlichen Ausdehnung kleiner als die Probenoberfläche 5 (Probengrösse z. B. 1 mm x 1 mm), die vom Ionenstrahl 8 überstrichen wird. Signalbeiträge aus der Umgebung der Probe 5 werden dadurch eliminiert, dass die Probe 5 im Prinzip trägerfrei vor einem Loch 9 im Probenteller 2 montiert wird.

Die Oberfläche der Probe 5 befindet sich in derselben Ebene wie die Oberfläche des umgebenden Halterungsteiles 4. Dadurch wird bei gleichem elektrischen Potential beider Teile 4 und 5 im Raum zwischen Probenteller und Massenspektrometer derselbe elektrische Feldverlauf angenähert, wie er sich bei Vorhandensein eines ebenen Probentellers ohne Loch (herkömmliche Bauweise) ergibt. Praktisch kann es vorteilhaft sein, die Oberfläche der Probe 5 um einen geringen Betrag vor die Vorderebene des Teiles 4 vorstehen zu lassen, um ein Belegen der Probenoberfläche 5 mit von Teil 4 abgesputtertem Material während der Proben- und Gerätejustierung ausschliessen zu können. Ebenso kann es zweckmässig oder erforderlich sein, die Teile 4 und 5 auf unterschiedliche elektrische Potentiale zu legen, um z. B. bei schlecht leitfähigen Proben während des Beschusses mit Ionen und gegebenenfalls auch Elektronen die gewünschte Feldverteilung zu erzielen. In diesem Falle wäre der Haltearm 6 mit dem Halteteil 4 über ein hier nicht gezeichnetes Isolierstück mechanisch zu verbinden und elektrisch getrennt zu kontaktieren.

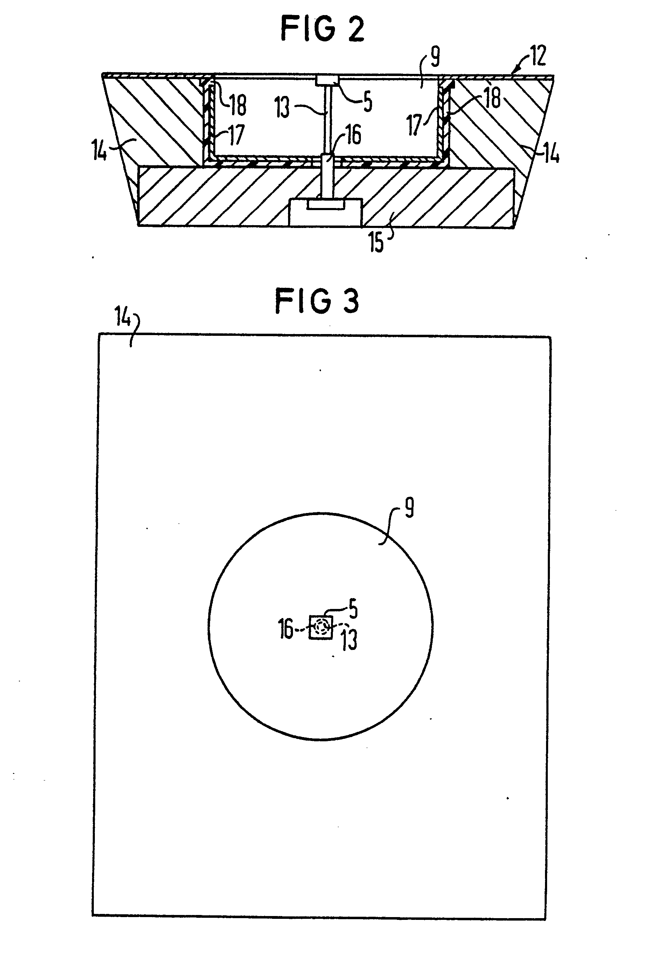

Das gleiche Prinzip gilt auch für die in Figur 2 und 3 dargestellte Ausführungsform. Hier hat das Loch 9 nur eine geringe Tiefe von ca. 5 mm. Die Probe 5 wird dabei auf einem, in der Mitte des Probentellers 12 angeordneten Stift 13 leitend aufgeklebt, wobei der Stift 13 über eine Justierschraube 16 durch eine, den Probenteller 12 tragende Grundplatte 15 geführt und axial in der Höhe verschiebbar ist. Auch hier ist die flächenmässige Ausdehnung der Probe 5 grösser als das stiftförmige Podest 13, welches die Probe 5 trägt. Die Berandung des sogenannten Loches 9 bildet der äussere Probenteller 14. Die durch die Anordnung der beiden Teile 13 und 14 im Probenteller 12 entstehende Vertiefung (9) ist mit einer gegenüber der Grundplatte 15 und dem äusseren Randbereich 14 elektrisch isolierten Metallverkleidung 17 z. B. aus Edelstahl oder Aluminium versehen, die im Bereich des Zentrierstiftes 13 am Boden des Probentellers 12 unterbrochen ist. Die Probe 5 liegt bei dieser Ausführungsform auf demselben Potential wie der Teil 14 des Probentellers 12, der die Berandung des Loches 9 bildet. Dadurch wird annähernd die gleiche Feldverteilung in dem Raum zwischen Probe 5 und Massenspektrometer sichergestellt wie bei den bekannten Probenhalterungen.

Die Metallverkleidung kann gegenüber dem Probenteller 12 (Teil 13 und 14) auf ein geeignetes Potential gelegt werden, um Sekundärionen vom Boden des Loches 9 am Verlassen des Loches 9 zu hindern. Mit dem Bezugszeichen 18 sind Isolierscheiben bezeichnet. Es ist auch möglich, den Lochdurchmesser durch Einlegen von Blenden zu verringern.

In Figur 3 sind die gleichen Bezugszeichen verwendet wie in Figur 2.

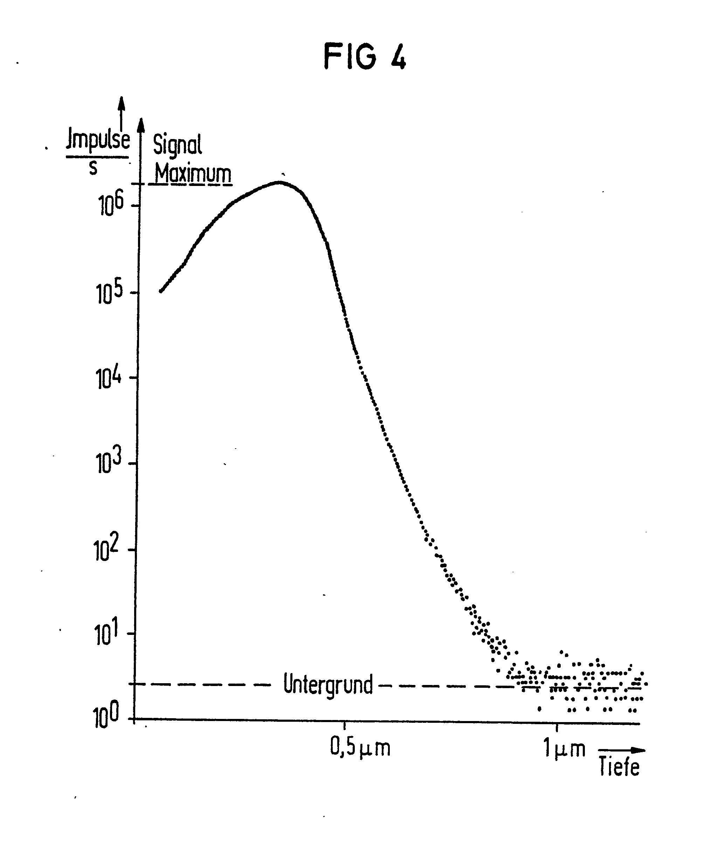

In Figur 4 ist der Konzentrationsverlauf von ionenimplantiertem Bor (Dosis $10^{16}$ cm$^{-2}$, Energie 70 keV) in einer Siliziumkristallscheibe aufgetragen. Dabei dient als Abszisse die Tiefe ($\mu$m) und als Ordinate die Impulsrate (Impulse/s) des Messsignals von $M_B+$. Die Messung erfolgt unter Verwendung eines $O^+_2$-Ionenstrahles (12 keV, 2 $\mu$A).

Dieses «Tiefenprofil» zeigt einen Verlauf des BorSignals über fast 6 Dekaden vom Maximum bis zum konstanten Signaluntergrund.

Eine derartig hohe Dynamik wurde bisher an einem baugleichen Gerät, jedoch mit herkömmlicher Probenhalterung, lediglich von Wittmaack und Clegg (siehe Beschreibungseinleitung) erreicht, jedoch waren hierzu ein erheblicher Optimierungsaufwand und sehr gute Vakuumbedingungen erforderlich. Demgegenüber wurde die vorgelegte Messung (siehe Figur 4) bei einem routinenmässig und rasch erreichbaren Totaldruck von grösser als $10^{-6}$Pa ($\sim 10^{-8}$ Torr) und ohne aufwendige Optimierung durchgeführt. Zusätzlich war die gemessene Probe simultan mit einem Elektronenstrahl (30 mA, 500 eV) beschossen worden, um Aufladungseffekte zu minimalisieren. Unter diesen Bedingungen wird bei der bislang üblichen Halterungs- und Untersuchungstechnik auch die Probenoberfläche in der Umgebung des Sputterkraters von Elektronen getroffen und kann einen unerwünschten Signaluntergrund bewirken, den die Messkurve z. B. schon vier bis fünf Grössenordnungen unterhalb des Maximums erreicht.

**Patentansprüche**

1. Elektrisch leitende Probenhalterung für die Analysentechnik der Sekundärionen-Massenspektrometrie, bei der die zu analysierende Probe im Vakuum mit einem Ionen- oder Neutralteilchenstrahl beschossen wird, hierdurch an der getroffenen Stelle abgetragen wird und die bei der Abtragung entstehenden Sekundärionen in einem Massenspektrometer analysiert werden, gekennzeichnet durch einen, die Probe (5) aufnehmenden Probenteller (2), der bezüglich seiner dem Ionen- oder Nentralteilchenstrahl (8) zugewandten Oberfläche so beschaffen ist, dass die Probe (5) umgebungsfrei voll im Inneren des vom Ionen- oder Neutralteilchenstrahl (8) getroffenen oder überstrichenen Bereiches angeordnet ist.

2. Probenhalterung nach Anspruch 1, dadurch gekennzeichnet, dass der Probenteller (2) aus mindestens zwei, vorzugsweise konzentrisch zueinander angeordneten Teilen (3, 4) besteht, von dem das innerste Teil (3) die Probe (5) trägt und bezüglich seiner räumlichen Ausdehnung kleiner ist als die Probenoberfläche (5), die vom Ionen- oder Neutralteilchenstrahl (8) getroffen oder überstrichen wird, das äussere Teil (4) mit räumlichem Abstand vom inneren Teil (3) angeordnet ist und dass ein Haltearm (6) vorgesehen ist, der das innere Teil (3) mechanisch und elektrisch mit dem äusseren Teil (4) des Probentellers (2) verbindet (Figur 1).

3. Probenhalterung nach Anspruch 1, dadurch gekennzeichnet, dass der Probenteller (2) in seinem inneren Bereich eine Vertiefung (9) aufweist, in deren Zentrum ein stiftförmiges Podest (13) für die zu analysierende Probe (5) angeordnet ist, welches durch eine den Probenteller (12) tragende Grundplatte (15) geführt ist und über die Grundplatte (15) mit dem Probenteller (12) mechanisch und elektrisch verbunden ist (Figuren 2 und 3).

4. Probenhalterung nach Anspruch 3, dadurch gekennzeichnet, dass das Podest (13) für die Probe (5) als Zentrierstift (13) ausgebildet und in der Höhe verstellbar ist (Figur 2).

5. Probenhalterung nach Anspruch 3 und/oder 4, dadurch gekennzeichnet, dass die Vertiefung (9) im Probenteller (12) mit einer gegenüber der Grundplatte (15) und dem äusseren Randbereich (14) elektrisch isolierten Metallverkleidung (17) versehen ist, die im Bereich des Zentrierstiftes (13) unterbrochen ist (Figuren 2 und 3).

6. Probenhalterung nach Anspruch 3 bis 5, dadurch gekennzeichnet, dass das stiftförmige Podest oder der Zentrierstift (13) mit der Probe (9) auf gleiches Potential gelegt ist wie der äussere Bereich (14) des Probentellers (12) (Figuren 2 und 3).

7. Probenhalterung nach Anspruch 3 bis 6, dadurch gekennzeichnet, dass die Metallverkleidung (17) gegenüber dem Probenteller (12) [äusserer Bereich (14) und Stift (13)] auf unterschiedliches Potential gelegt ist (Figuren 2 und 3).

8. Probenhalterung nach einem der Ansprüche 1 bis 7, dadurch gekennzeichnet, dass die zu analysierende Probe (5) quadratische Form aufweist, wobei die Kantenlänge so bemessen wird, dass die gesamte Probenoberfläche (5) kleiner ist als der vom Ionenstrahl (8) quadratisch überstrichene Bereich (Figur 1).

9. Verwendung der Probenhalterung nach einem der Ansprüche 1 bis 8 zur Messung von Tiefenprofilen von ionenimplantierten Bereichen in Halbleiterkristallscheiben.

10. Verwendung der Probenhalterung nach einem der Ansprüche 1 bis 8 zum höchstempfindlichen Nachweis spurenhafter Verunreinigungen in Festkörpern.

**Claims**

1. An electrically conductive sample holder for secondary ion mass spectrometry analysis, in which the sample to be analysed is bombarded in a vacuum by an ion or neutral particle beam, and is thereby eroded at the point of impact, and the secondary ions which are produced during the erosion are analysed in a mass spectrometer, characterised by a sample dish (2) which receives the sample (5) and the surface of which facing toward the ion neutral particle beam (8), being so designed that the sample (5) is arranged, free from immediate surroundings, wholly within the zone which is hit or swept over the ion or neutral particle beam (8).

2. A sample holder as claimed in Claim 1, characterised in that the sample dish (2) consists of at least two parts (3, 4) which are preferably arranged concentrically with one another and of which, the inner part (3) carries the sample (5) and is smaller as regards its spatial dimensions than the sample surface (5) which is hit or swept over by the ion or neutral particle beam (8), the outer part (4) being spaced from the inner part (3); and that a support arm (6) is provided which connects the inner part (3) to the outer part (4) of the sample dish (2), both mechanically and electrically (Fig. 1).

3. A sample holder as claimed in Claim 1, characterised in that, the sample dish (2) has a recess (9) in its inner region, in the centre of which there is arranged a pin-shaped platform (13) for the sample (5) which is to be analysed, which platform passes through a base plate (15) which supports the sample dish (12), and is mechanically and electrically connected to the sample dish (12) by way of the base plate (15) (Figs. 2 and 3).

4. A sample holder as claimed in Claim 3, characterised in that the platform (13) for the sample (5) is designed as a centering pin (13) and is adjustable in height (Fig. 2).

5. A sample holder as claimed in Claim 3 and/or 4, characterised in that the recess (9) in the sample dish (12) is provided with a metal lining (17) which is electrically insulated from the base plate (15) and the outer edge region (14), and which is interrupted in the region of the centering pin (13) (Figs. 2 and 3).

6. A sample holder as claimed in Claim 3 to 5, characterised in that the pin-shaped platform, or the centering pin (13), with the sample (9), is at the same potential as the outer region (14) of the sample dish (12) (Figs. 2 and 3).

7. A sample holder as claimed in Claim 3 to 6, characterised in that the metal lining (17) carries a different potential as compared with the sample dish (12) [outer region (14), and pin (13)], (Figs. 2 and 3).

8. A sample holder as claimed in one of Claims 1 to 7, characterised in that the sample (5) which is to be analysed is of square shape, and its edge length is such that the entire surface of the sample (5) is smaller than the zone which is swept over in the form of a square by the beam (8) (Fig. 1).

9. The use of the sample holder as claimed in one of Claims 1 to 8, for measuring depth profiles of ion-implanted zones in semiconductor crystal wafers.

10. The use of the sample holder as claimed in one of Claims 1 to 8 for the high-sensitivity detection of traceable impurities in solids.

**Revendications**

1. Porte-échantillon électriquement conducteur pour la technique d'analyse de spectrométrie de masse par émission d'ions secondaires, dans laquelle l'échantillon à analyser est bombardé sous vide par un faisceau d'ions ou de particules neutres, est ainsi érodé à l'endroit frappé et les ions secondaires provenant de l'érosion sont analysés dans un spectromètre de masse, caractérisé par un plateau (2) de réception de l'échantillon (5), dont la surface se trouvant du côté du faisceau d'ions ou de particules neutres (8) est telle que l'échantillon (5) est disposé sans entourage, entièrement à l'intérieur de la région frappée ou balayée par le faisceau d'ions ou de particules neutres.

2. Porte-échantillon suivant la revendication 1, caractérisé en ce que le plateau (2) de réception de l'échantillon est constitué d'au moins deux parties (3, 4), disposées de préférence concentriquement l'une par rapport à l'autre, la partie (3) intérieure portant l'échantillon (5) et ayant une étendue spatiale plus petite que la surface (5) de l'échantillon qui est frappée ou balayée par le faisceau d'ions de particules neutres (8), la partie extérieure (4) étant disposée, à distance dans l'espace, de la partie intérieure (3) et en ce qu'il est prévu un bras de maintien (6) qui relie mécaniquement et électriquement la partie intérieure (3) à la partie extérieure (4) du plateau (2) de réception de l'échantillon (figure 1).

3. Porte-échantillon suivant la revendication 1, caractérisé en ce que le plateau (2) de réception de l'échantillon présente dans sa région intérieure une cavité (9) au centre de laquelle est disposé un pied (13) en forme de tige pour l'échantillon (5) à analyser, ce pied étant guidé par une plaque de base (15) portant le plateau (12) de réception de l'échantillon et étant relié mécaniquement et électriquement par la plaque de base (15) au plateau (12) de réception de l'échantillon (figures 2 et 3).

4. Porte-échantillon suivant la revendication 3, caractérisé en ce que le pied (13) pour l'échantillon (5) est agencé en tige de centrage (13) et réglable en hauteur (figure 2).

5. Porte-échantillon suivant la revendication 3 et/ou 4, caractérisé en ce que la cavité (9) ménagée dans le plateau (12) de réception de l'échantillon est munie d'un revêtement métallique (17) qui est isolé par rapport à la plaque de base (15) et par rapport à la région marginale extérieure (14) et qui est interrompu dans la région de la tige de centrage (13) (figures 2 et 3).

6. Porte-échantillon suivant l'une des revendications 3 à 5, caractérisé en ce que le pied en forme de tige ou la tige de centrage (13) avec l'échantillon (9) est mis au même potentiel que la région extérieure (14) du plateau (12) de réception de l'échantillon (figures 2 et 3).

7. Porte-échantillon suivant l'une des revendications 3 à 6, caractérisé en ce que le revêtement métallique (17) est mis à un potentiel différent de celui du plateau (12) de réception de l'échantillon [région extérieure 14 et tige (13)] (figures 2 et 3).

8. Porte-échantillon suivant l'une des revendications 1 à 7, caractérisé en ce que l'échantillon (5) à analyser présente une forme carrée, les longueurs des côtés étant telles que la surface totale de l'échantillon (5) est inférieure à la région balayée en carrée par le faisceau d'ions (8) (figure 1).

9. Utilisation du porte-échantillon suivant l'une des revendications 1 à 8, pour la mesure des profils des profondeurs de régions à implantation d'ions dans des plaquettes en cristaux semi-conducteurs.

10. Utilisation du porte-échantillon suivant l'une des revendications 1 à 8, pour la détection très sensible d'impuretés sous forme de traces dans des corps solides.

# FIG 1

# FIG 2

# FIG 3

# FIG 4